# EUROPEAN PATENT SPECIFICATION

(11) **EP 3 139 414 B1**
(45) Date of publication and mention of the grant of the patent: **04.12.2019**
(21) Application number: 16186990.4
(22) Date of filing: 02.09.2016
(51) Int. Cl.: H01L 31/0224, H01L 31/05, H01L 31/068

(54) **SOLAR CELL MODULE**
SOLARZELLENMODUL
MODULE DE CELLULE SOLAIRE

(30) Priority: 04.09.2015 KR 20150125286
(43) Date of publication of application: 08.03.2017
(73) Proprietor: LG ELECTRONICS INC., Yeongdeungpo-gu Seoul 07336 (KR)
(72) Inventor: JANG, Daehee, Seoul 08592 (KR); KIM, Bojoong, Seoul 08592 (KR); HYUN, Daeseon, Seoul 08592 (KR)
(74) Representative: Katérle, Axel

(56) References cited:
- EP-A1- 2 184 787
- EP-A1- 2 911 207
- EP-A2- 2 911 206

## Description

### CROSS-REFERENCE TO RELATED APPLICATION

### BACKGROUND OF THE INVENTION

### Field of the Invention

Embodiments of the invention relate to a solar cell module.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes by the incident light. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

A plurality of solar cells having the above-described configuration may be connected to one another through interconnectors to form a module.

EP 2 911 207 A1 discloses a solar cell module including first and second solar cells each including a plurality of first and second electrodes formed on a back surface of a semiconductor substrate and separated from each other, a first conductive line connected to the plurality of first electrodes, and a second conductive line connected to the plurality of second electrodes; and an interconnector adhesive formed of a conductive material configured to electrically connect the first conductive line of the first solar cell to the second conductive line of the second solar cell. EP 2 911 206 A2 discloses a solar cell comprising a plurality of solar cells each including a semiconductor substrate and a plurality of first electrodes and a plurality of second electrodes, which are formed on a back surface of the semiconductor substrate and are separated from each other, and a plurality of conductive lines connected to the plurality of first electrodes included in one of the plurality of solar cells and the plurality of second electrodes included in other solar cell adjacent to the one solar cell. A conductive adhesive connects the conductive lines to the electrodes and an insulating layer is positioned between respective conductive lines and electrodes.

### SUMMARY OF THE INVENTION

A solar cell according to the present invention is defined in claim 1. Preferred features are defined in the dependent claims. In one aspect useful for understanding the invention, there is provided a solar cell module including a plurality of solar cells each including a semiconductor substrate and first and second electrodes that are formed on a back surface of the semiconductor substrate, the first and second electrodes extending in a first direction, and having different polarities, and conductive lines disposed to extend in a second direction crossing the first direction on the back surface of the semiconductor substrate included in each solar cell, the conductive lines being connected to the first and second electrodes through a conductive adhesive or being insulated from the first and second electrodes through an insulating layer, wherein a first direction length of the conductive adhesive in the first direction and a first direction length of the insulating layer in the first direction are equal to or greater than a linewidth of each conductive line and are less than a distance between the conductive lines, and wherein the first direction length of the insulating layer is greater than the first direction length of the conductive adhesive.

For example, a ratio of the linewidth of the each conductive line to the first direction length of the insulating layer may be 1: 1.1 to 1: 2.

Further, a ratio of the linewidth of the each conductive line to the first direction length of the conductive adhesive may be 1: 1 to 1: 1.25.

The linewidth of the each conductive line may be 1 mm to 2.5 mm. The distance between the conductive lines may be equal to or greater than 2 mm and may be equal to or less than 0.5 times a length of the semiconductor substrate in the second direction. More preferably, the distance between the conductive lines may be 4 mm to 8 mm.

A ratio of the first direction length of the conductive adhesive to the first direction length of the insulating layer may be 1: 1.1 to 1: 1.7.

For example, the first direction length of the conductive adhesive may be 1 mm to 3 mm, and the first direction length of the insulating layer may be 1.1 mm to 4 mm.

A linewidth of each of the first and second electrodes may be less than the first direction length of the conductive adhesive and the first direction length of the insulating layer. For example, a linewidth of each of the first and second electrodes may be 180 µm to 400 µm.

A distance between the first and second electrodes may be less than the first direction length of the conductive adhesive and the first direction length of the insulating layer. For example, a distance between the first and second electrodes may be 0.5 mm to 1.5 mm.

A linewidth of the insulating layer may be greater than a linewidth of the conductive adhesive. For example, the linewidth of the conductive adhesive may be substantially equal to a linewidth of each of the first and second electrodes.

More specifically, the linewidth of the conductive adhesive may be 180 µm to 400 µm, and the linewidth of the insulating layer may be 200 µm to 450 µm.

The semiconductor substrate of each solar cell may be doped with impurities of a first conductive type. The each solar cell may further include an emitter region doped with impurities of a second conductive type opposite the first conductive type on the back surface of the semiconductor substrate and a back surface field region more heavily doped than the semiconductor substrate with impurities of the first conductive type. Each first electrode may be connected to the emitter region, and each second electrode may be connected to the back surface field region.

The conductive lines may include first conductive lines connected to the first electrodes through the conductive adhesive and insulated from the second electrodes through the insulating layer, and second conductive lines connected to the second electrodes through the conductive adhesive and insulated from the first electrodes through the insulating layer.

The plurality of solar cells may include a first solar cell and a second solar cell that are arranged next to each other in the second direction and are connected in series to each other. An interconnector may be disposed between the first solar cell and the second solar cell and may connect the first solar cell and the second solar cell in series.

The interconnector may be disposed to extend between the first solar cell and the second solar cell in the first direction. The first conductive lines connected to the first solar cell and the second conductive lines connected to the second solar cell may be commonly connected to the interconnector.

The first conductive lines and the second conductive lines may be alternatingly arranged on the interconnector.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 illustrates an example of a string applied to a solar cell module according to an embodiment of the invention when viewed from a back surface;
FIG. 2 is a partial perspective view illustrating an example of a solar cell applied to a solar cell module shown in FIG. 1;
FIG. 3 is a cross-sectional view of a solar cell shown in FIG. 2 in a second direction;
FIG. 4 is a cross-sectional view taken along line csx1-csx1 of FIG. 1;
FIG. 5 illustrates in detail a length of a conductive adhesive in a first direction and a length of an insulating layer in the first direction; and
FIG. 6 illustrates another example of a solar cell module according to an embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" may be one surface of a semiconductor substrate, on which light is directly incident, and "back surface" may be a surface opposite the one surface of the semiconductor substrate, on which light is not directly incident or reflective light may be incident.

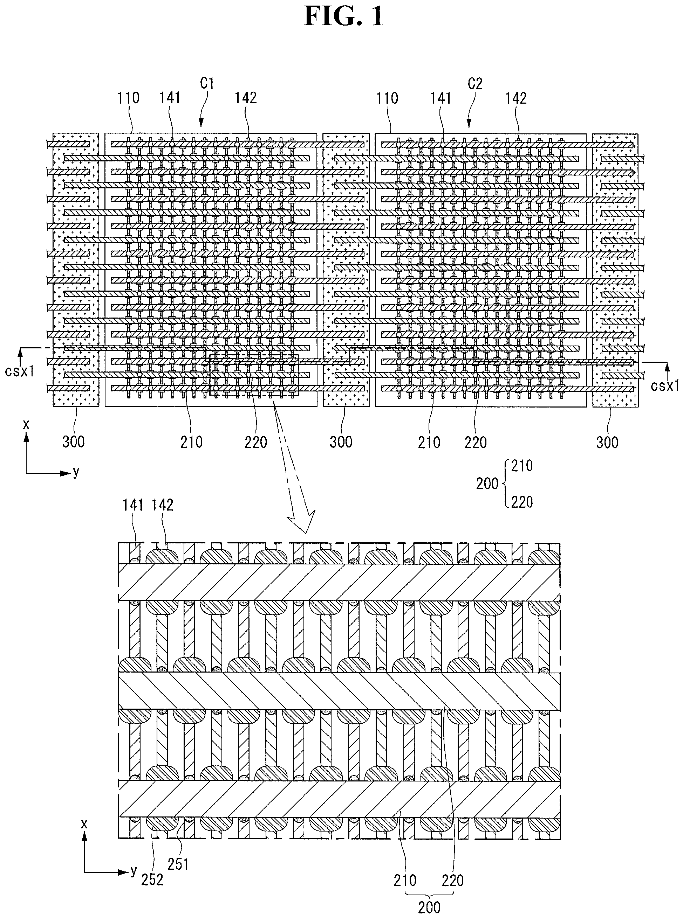

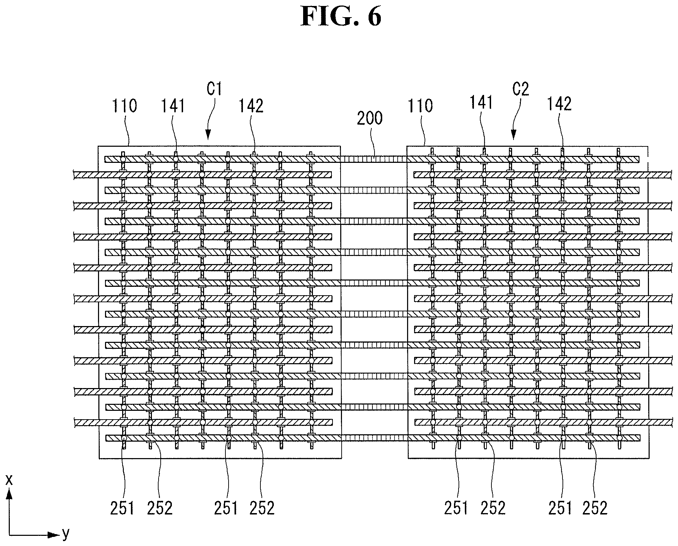

FIGS. 1 to 4 illustrate an example of a solar cell module according to an embodiment of the invention. FIG. 6 illustrates another example of a solar cell module according to an embodiment of the invention.

FIG. 1 illustrates an example of a string applied to a solar cell module according to an embodiment of the invention when viewed from a back surface.

As shown in FIG. 1, a solar cell module according to an embodiment of the invention includes a plurality of solar cells C1 and C2, a plurality of first and second conductive lines 210 and 220 connected to a plurality of first and second electrodes 141 and 142 formed on a back surface of each of the plurality of solar cells C1 and C2, and an interconnector 300 that is connected to the plurality of first and second conductive lines 210 and 220 and connects the plurality of solar cells C1 and C2, for example, in series.

In the embodiment disclosed herein, each of the plurality of solar cells C1 and C2 includes a semiconductor substrate 110 and the plurality of first and second electrodes 141 and 142 that are spaced apart from each other on a back surface of the semiconductor substrate 110 and extend in a first direction x.

The plurality of first and second conductive lines 210 and 220 may electrically connect in series a plurality of first electrodes 141 included in one solar cell of two adjacent solar cells among a plurality of solar cells to a plurality of second electrodes 142 included in the other solar cell through an interconnector 300.

To this end, the plurality of first and second conductive lines 210 and 220 may extend in a second direction y crossing a longitudinal direction (i.e., the first direction x) of the first and second electrodes 141 and 142 and may be connected to each of the plurality of solar cells.

For example, a plurality of conductive lines 200 may include the plurality of first conductive lines 210 and the plurality of second conductive lines 220.

As shown in FIG. 1, the first conductive line 210 may be connected to the first electrode 141 included in each solar cell using a conductive adhesive 251 and may be insulated from the second electrode 142 of each solar cell through an insulating layer 252 formed of an insulating material.

Further, the second conductive line 220 may be connected to the second electrode 142 included in each solar cell using a conductive adhesive 251 and may be insulated from the first electrode 141 of each solar cell through an insulating layer 252 formed of an insulating material.

Each of the first and second conductive lines 210 and 220 may be connected to the interconnector 300 that is positioned between the plurality of solar cells and extends in the first direction x. Hence, the plurality of solar cells may be connected in series in the second direction y.

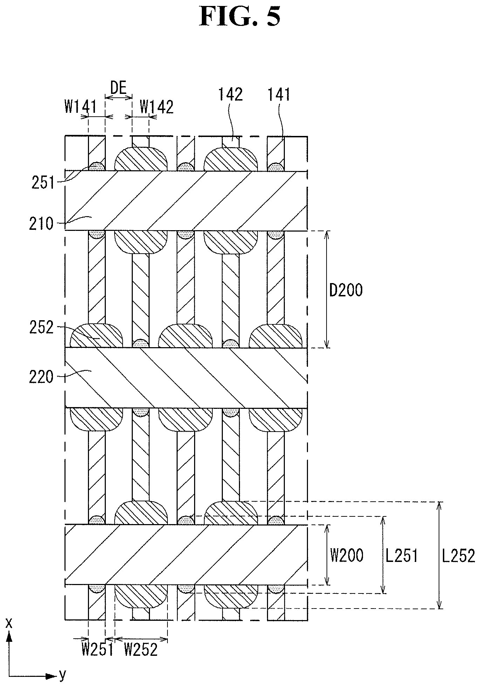

The solar cell module according to the embodiment of the invention may set a length (hereinafter, referred to as "first direction length") L252 of the insulating layer 252 in the first direction x to be greater than a length (hereinafter, referred to as "first direction length") L251 of the conductive adhesive 251 in the first direction x, so as to minimize a short circuit between the unintended electrode 141 or 142 and the conductive line 200 when the conductive line 200 is connected to the back surface of the semiconductor substrate 110 in a manufacturing process. This is described in detail later with reference to FIG. 5.

The embodiment of the invention is illustrated and described using a solar cell module including the interconnector 300 as an example. However, as shown in FIG. 6, the interconnector 300 may be omitted. When the interconnector 300 is omitted as shown in FIG. 6, the first and second conductive lines 210 and 220 may be combined to form a conductive line 200. Further, first electrodes 141 of a first solar cell C1 and second electrodes 142 of a second solar cell C2 may be connected to the conductive line 200 using a conductive adhesive 251, and thus the plurality of solar cells C1 and C2 may be connected in series to each other.

Each of the plurality of solar cells is described in detail below.

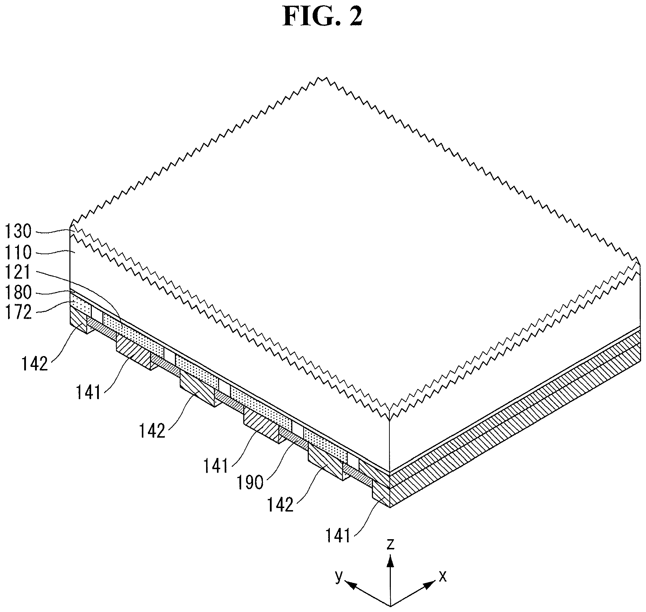

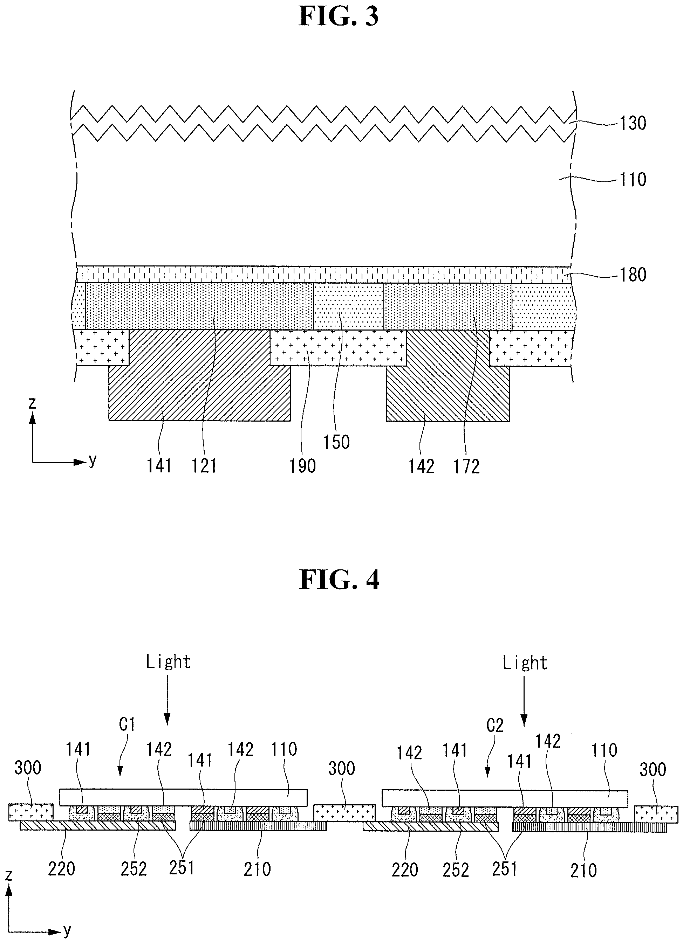

FIG. 2 is a partial perspective view illustrating an example of a solar cell applied to a solar cell module shown in FIG. 1. FIG. 3 is a cross-sectional view of a solar cell shown in FIG. 2 in a second direction.

As shown in FIGS. 2 and 3, an example of a solar cell according to the embodiment of the invention may include an anti-reflection layer 130, a semiconductor substrate 110, a tunnel layer 180, a plurality of emitter regions 121, a plurality of back surface field regions 172, a plurality of intrinsic semiconductor layers 150, a passivation layer 190, a plurality of first electrodes 141, and a plurality of second electrodes 142.

In the embodiment disclosed herein, the anti-reflection layer 130, the intrinsic semiconductor layer 150, the tunnel layer 180, and the passivation layer 190 may be omitted, if desired or necessary.

However, when the solar cell includes them, efficiency of the solar cell may be further improved. Thus, the embodiment of the invention is described using the solar cell including the anti-reflection layer 130, the intrinsic semiconductor layer 150, the tunnel layer 180, and the passivation layer 190, as an example.

The semiconductor substrate 110 may be formed of at least one of single crystal silicon and polycrystalline silicon containing impurities of a first conductive type. For example, the semiconductor substrate 110 may be formed of a single crystal silicon wafer.

In the embodiment disclosed herein, the first conductive type may be one of an n-type and a p-type.

When the semiconductor substrate 110 is of the p-type, the semiconductor substrate 110 may be doped with impurities of a group III element, such as boron (B), gallium (Ga), and indium (In). Alternatively, when the semiconductor substrate 110 is of the n-type, the semiconductor substrate 110 may be doped with impurities of a group V element, such as phosphorus (P), arsenic (As), and antimony (Sb).

In the following description, the embodiment of the invention is described using an example where the first conductive type is the n-type.

A front surface of the semiconductor substrate 110 may be an uneven surface having a plurality of uneven portions or having uneven characteristics. Thus, the emitter regions 121 positioned on the front surface of the semiconductor substrate 110 may have an uneven surface.

Hence, an amount of light reflected from the front surface of the semiconductor substrate 110 may decrease, and an amount of light incident on the inside of the semiconductor substrate 110 may increase.

The anti-reflection layer 130 may be positioned on the front surface of the semiconductor substrate 110, so as to minimize a reflection of light incident on the front surface of the semiconductor substrate 110 from the outside. The anti-reflection layer 130 may be formed of at least one of aluminum oxide (AlOx), silicon nitride (SiNx), silicon oxide (SiOx), and silicon oxynitride (SiOxNy).

The tunnel layer 180 is disposed on an entire back surface of the semiconductor substrate 110 while directly contacting the entire back surface of the semiconductor substrate 110 and may include a dielectric material. Thus, as shown in FIGS. 2 and 3, the tunnel layer 180 may pass through carriers produced in the semiconductor substrate 110.

In other words, the tunnel layer 180 may pass through carriers produced in the semiconductor substrate 110 and may perform a passivation function with respect to the back surface of the semiconductor substrate 110.

The tunnel layer 180 may be formed of a dielectric material including silicon carbide (SiCx) or silicon oxide (SiOx) having strong durability at a high temperature equal to or higher than 600 °C. Other materials may be used. For example, the tunnel layer 180 may be formed of silicon nitride (SiNx), hydrogenated SiNx, aluminum oxide (AlOx), silicon oxynitride (SiON), or hydrogenated SiON. A thickness of the tunnel layer 180 may be 0.5 nm to 2.5 nm.

The plurality of emitter regions 121 is disposed on the back surface of the semiconductor substrate 110, and more specifically directly contacts a portion of a back surface of the tunnel layer 180. The plurality of emitter regions 121 extends in the first direction x. The emitter regions 121 may be formed of polycrystalline silicon material of a second conductive type opposite the first conductive type. The emitter regions 121 may form a p-n junction together with the semiconductor substrate 110 with the tunnel layer 180 interposed therebetween.

Because each emitter region 121 forms the p-n junction together with the semiconductor substrate 110, the emitter region 121 may be of the p-type. However, if the semiconductor substrate 110 is of the p-type unlike the embodiment described above, the emitter region 121 may be of the n-type. In this instance, separated electrons may move to the plurality of emitter regions 121, and separated holes may move to the plurality of back surface field regions 172.

Returning to the embodiment of the invention, when the emitter region 121 is of the p-type, the emitter region 121 may be doped with impurities of a group III element such as B, Ga, and In. On the contrary, if the emitter region 121 is of the n-type, the emitter region 121 may be doped with impurities of a group V element such as P, As, and Sb.

The plurality of back surface field regions 172 is disposed on the back surface of the semiconductor substrate 110. More specifically, the plurality of back surface field regions 172 may directly contact a portion (spaced apart from each of the plurality of emitter regions 121) of the back surface of the tunnel layer 180. The plurality of back surface field regions 172 may extend in the first direction x parallel to the plurality of emitter regions 121.

The back surface field regions 172 may be formed of polycrystalline silicon material more heavily doped than the semiconductor substrate 110 with impurities of the first conductive type. Thus, when the semiconductor substrate 110 is doped with, for example, n-type impurities, each of the plurality of back surface field regions 172 may be an n⁺-type region.

A potential barrier is formed by a difference between impurity concentrations of the semiconductor substrate 110 and the back surface field regions 172.

Hence, the back surface field regions 172 can prevent or reduce holes from moving to the back surface field regions 172 used as a moving path of electrons through the potential barrier and can make it easier for carriers (for example, electrons) to move to the back surface field regions 172.

Thus, the embodiment of the invention can reduce an amount of carriers lost by a recombination and/or a disappearance of electrons and holes at and around the back surface field regions 172 or at and around the first and second electrodes 141 and 142 and can accelerates a movement of electrons, thereby increasing an amount of electrons moving to the back surface field regions 172.

FIGS. 2 and 3 illustrate that the emitter regions 121 and the back surface field regions 172 are formed on the back surface of the tunnel layer 180 using polycrystalline silicon material, as an example. Unlike FIGS. 2 and 3, if the tunnel layer 180 is omitted, the emitter regions 121 and the back surface field regions 172 may be doped by diffusing impurities into the back surface of the semiconductor substrate 110. In this instance, the emitter regions 121 and the back surface field regions 172 may be formed of the same material (for example, single crystal silicon) as the semiconductor substrate 110.

The intrinsic semiconductor layer 150 may be formed on the back surface of the tunnel layer 180 exposed between the emitter region 121 and the back surface field region 172.

The intrinsic semiconductor layer 150 may be formed as an intrinsic polycrystalline silicon layer, that is not doped with impurities of the first conductive type or impurities of the second conductive type, unlike the emitter region 121 and the back surface field region 172.

Further, as shown in FIGS. 2 and 3, the intrinsic semiconductor layer 150 may be configured such that both sides directly contact the side of the emitter region 121 and the side of the back surface field region 172, respectively.

The passivation layer 190 removes a defect resulting from a dangling bond formed in a back surface of a polycrystalline silicon layer formed at the back surface field regions 172, the intrinsic semiconductor layers 150, and the emitter regions 121, and thus can prevent carriers produced in the semiconductor substrate 110 from being recombined and disappeared by the dangling bond.

To this end, the passivation layer 190 may cover a remaining portion except a portion, on which the first and second electrodes 141 and 142 are formed, from the back surface of the semiconductor substrate 110.

The passivation layer 190 may be formed of a dielectric material. For example, the passivation layer 190 may be formed of at least one of hydrogenated silicon nitride (SiNx:H), hydrogenated silicon oxide (SiOx:H), hydrogenated silicon nitride oxide (SiNxOy:H), hydrogenated silicon oxynitride (SiOxNy:H), and hydrogenated amorphous silicon (a-Si:H).

The first electrode 141 may be connected to the emitter region 121 and may extend in the first direction x. The first electrode 141 may collect carriers (for example, holes) moving to the emitter region 121.

The second electrode 142 may be connected to the back surface field region 172 and may extend in the first direction x in parallel with the first electrode 141. The second electrode 142 may collect carriers (for example, electrons) moving to the back surface field region 172.

As shown in FIG. 1, the first and second electrodes 141 and 142 may extend in the first direction x and may be alternately disposed in the second direction y.

The first and second electrodes 141 and 142 may include a metal material different from the conductive line 200 and the conductive adhesive 251. For example, each of the first and second electrodes 141 and 142 may be formed as at least one layer including at least one of titanium (Ti), silver (Ag), aluminum (Al), nickel-vanadium (NiV) alloy, nickel (Ni), nickel-aluminum (NixAly) alloy, molybdenum (Mo), or tin (Sn).

The first and second electrodes 141 and 142 may be formed using one of a sputtering method, an electron beam evaporator, an electroless plating method, and an electroplating method.

In the solar cell having the above-described structure according to the embodiment of the invention, holes collected by the first electrodes 141 and electrons collected by the second electrodes 142 may be used as electric power of an external device through an external circuit device.

The solar cell applied to the solar cell module according to the embodiment of the invention is not limited to FIGS. 2 and 3. The components of the solar cell may be variously changed, except that the first and second electrodes 141 and 142 included in the solar cell are formed on the back surface of the semiconductor substrate 110.

For example, the solar cell module according to the embodiment of the invention may use a metal wrap through (MWT) solar cell, that is configured such that a portion of the first electrode 141 and the emitter region 121 are positioned on the front surface of the semiconductor substrate 110, and the portion of the first electrode 141 is connected to a remaining portion of the first electrode 141 formed on the back surface of the semiconductor substrate 110 through a hole of the semiconductor substrate 110.

FIG. 4 illustrates a cross-sectional structure, in which the plurality of solar cells each having above-described configuration are connected in series using the conductive lines 200 and the interconnector 300 as shown in FIG. 1.

More specifically, FIG. 4 is a cross-sectional view taken along line csx1-csx1 of FIG. 1.

As shown in FIG. 4, a plurality of solar cells including a first solar cell C1 and a second solar cell C2 may be arranged in the second direction y.

A longitudinal direction of a plurality of first and second electrodes 141 and 142 included in the first and second solar cells C1 and C2 may correspond to the first direction x.

The first and second solar cells C1 and C2, that are arranged in the second direction y as described above, may be connected in series to each other in the second direction y using first and second conductive lines 210 and 220 and an interconnector 300 to form a string.

The first and second conductive lines 210 and 220 and the interconnector 300 may be formed of a conductive metal material. The first and second conductive lines 210 and 220 may be connected to a back surface of a semiconductor substrate 110 of each solar cell and then may be connected to the interconnector 300 for a serial connection of the solar cells.

Each of the first and second conductive lines 210 and 220 may have a conductive wire shape having a circular cross section or a ribbon shape, in which a linewidth is greater than a thickness.

More specifically, the plurality of first conductive lines 210 may overlap the plurality of first electrodes 141 included in each of the first and second solar cells C1 and C2 and may be connected to the plurality of first electrodes 141 through a conductive adhesive 251. Further, the plurality of first conductive lines 210 may be insulated from the plurality of second electrodes 142 included in each of the first and second solar cells C1 and C2 through an insulating layer 252 formed of an insulating material.

In this instance, as shown in FIGS. 1 and 4, each of the plurality of first conductive lines 210 may protrude to the outside of the semiconductor substrate 110 toward the interconnector 300 disposed between the first and second solar cells C1 and C2.

The plurality of second conductive lines 220 may overlap the plurality of second electrodes 142 included in each of the first and second solar cells C1 and C2 and may be connected to the plurality of second electrodes 142 through a conductive adhesive 251. Further, the plurality of second conductive lines 220 may be insulated from the plurality of first electrodes 141 included in each of the first and second solar cells C1 and C2 through an insulating layer 252 formed of an insulating material.

In this instance, as shown in FIGS. 1 and 4, each of the plurality of second conductive lines 220 may protrude to the outside of the semiconductor substrate 110 toward the interconnector 300 disposed between the first and second solar cells C1 and C2.

The conductive adhesive 251 may be formed of a metal material including tin (Sn) or Sn-containing alloy. The conductive adhesive 251 may be formed as one of a solder paste including Sn or Sn-containing alloy, an epoxy solder paste, in which Sn or Sn-containing alloy is included in an epoxy, and a conductive paste.

For example, when the conductive adhesive 251 is formed as the solder paste, the solder paste may include at least one metal material of Sn, SnBi, SnIn, SnAgCu, SnPb, SnBiCuCo, SnBiAg, SnPbAg, or SnAg. When the conductive adhesive 251 is formed as the epoxy solder paste, the epoxy solder paste may be formed by including at least one metal material of Sn, SnBi, SnIn, SnAgCu, SnPb, SnBiCuCo, SnBiAg, SnPbAg, or SnAg in an epoxy resin.

Further, when the conductive adhesive 251 is formed as the conductive paste, the conductive paste may be formed by including at least one metal material of Sn, SnBi, Ag, AgIn, or AgCu in a resin, for example, an epoxy.

The insulating layer 252 may be made of any material as long as an insulating material is used. For example, the insulating layer 252 may use one insulating material of an epoxy-based resin, polyimide, polyethylene, an acrylic-based resin, and a silicone-based resin.

As shown in an enlarged view of FIG. 1, the conductive adhesive 251 may be positioned only on the back surface of the first electrode or the second electrode positioned in a portion crossing the conductive line 200.

The insulating layer 252 may be positioned not only on the back surface of the first electrode or the second electrode positioned in a portion crossing the conductive line 200 but also on the back surface of the semiconductor substrate 110 around the back surface of the first electrode or the second electrode.

When the conductive adhesive 251 and the insulating layer 252 are positioned at the above-described position, a short circuit between the unintended electrode and the conductive line 200 can be more efficiently prevented.

As shown in FIGS. 1 and 4, a portion protruding to the outside of the semiconductor substrate 110 in each of the first and second conductive lines 210 and 220 connected to the back surface of each solar cell may be commonly connected to the back surface of the interconnector 300 between the first and second solar cells C1 and C2. Hence, the plurality of solar cells C1 and C2 may be connected in series to each other in the second direction y to form a string.

In the solar cell module having the above-described structure, when a bad connection between the first and second conductive lines 210 and 220 and the first and second electrodes 141 and 142 is generated in the plurality of solar cells, the first and second conductive lines 210 and 220 of a solar cell having the bad connection may be disconnected from the interconnector 300. Hence, only the bad solar cell can be easily replaced.

A first direction length L251 of the conductive adhesive 251 and a first direction length L252 of the insulating layer 252 are described in detail below.

FIG. 5 illustrates in detail a length of a conductive adhesive in a first direction and a length of an insulating layer in the first direction. More specifically, FIG. 5 illustrates an example of an enlarged view of a portion, in which the conductive lines 200 is attached to the back surface of the semiconductor substrate 110.

The descriptions duplicative with those described above may be briefly made or may be entirely omitted in FIG. 5. Further, configuration of FIG. 5 is illustrated using the solar cell module illustrated in FIGS. 1 to 4 as an example. However, the configuration of FIG. 5 may be equally applied to another example of a solar cell module shown in FIG. 6.

As shown in FIG. 5, a first direction length L251 of the conductive adhesive 251 and a first direction length L252 of the insulating layer 252 may be equal to or greater than a linewidth W200 of each conductive line 200 and may be less than a distance D200 between the conductive lines 200.

As shown in FIG. 5, the first direction length L251 of the conductive adhesive 251 indicates a maximum length between both ends of the conductive adhesive 251 protruding in the first direction x while overlapping the conductive line 200. Further, the first direction length L252 of the insulating layer 252 indicates a maximum length between both ends of the insulating layer 252 protruding in the first direction x while overlapping the conductive line 200.

As described above, the first direction length L251 of the conductive adhesive 251 and the first direction length L252 of the insulating layer 252 may be equal to or greater than the linewidth W200 of the conductive line 200 and may be less than the distance D200 between the conductive lines 200.

In this instance, the first direction length L252 of the insulating layer 252 may be greater than the first direction length L251 of the conductive adhesive 251.

Thereby, a contact resistance between the conductive line 200 and the plurality of first and second electrodes 141 and 142 can be sufficiently reduced by sufficiently connecting the conductive line 200 to the conductive adhesive 251 during a tabbing process for connecting the conductive line 200 to the back surface of the semiconductor substrate 110.

Further, when the first direction length L251 of the conductive adhesive 251 is less than the first direction length L252 of the insulating layer 252 as described above, the short circuit between the unintended electrode 141 or 142 and the conductive line 200 can be minimized during the tabbing process for connecting the conductive line 200 to the back surface of the semiconductor substrate 110.

However, when the first direction length L251 of the conductive adhesive 251 is equal to or greater than the first direction length L252 of the insulating layer 252, the conductive adhesive 251 may spread to an electrode having a different polarity and adjacent to an electrode to which the conductive adhesive 251 is contacted, and may be connected to the electrode of the different polarity. Hence, a short circuit between the unintended electrode 141 or 142 and the conductive line 200 may be generated.

On the other hand, in the embodiment of the invention, because the first direction length L252 of the insulating layer 252 is greater than the first direction length L251 of the conductive adhesive 251, the conductive adhesive 251 can be previously prevented from being connected to the adjacent electrode having a different polarity, even if the conductive adhesive 251 spreads in the second direction y during the tabbing process. Hence, a defective possibility of the solar cell module can be minimized.

More specifically, the first direction length L252 of the insulating layer 252 may be greater than the linewidth W200 of the conductive line 200 and may be less than the distance D200 between the conductive lines 200. For example, a ratio of the linewidth W200 of the conductive line 200 to the first direction length L252 of the insulating layer 252 may be 1: 1.1 to 1: 2.

When the first direction length L252 of the insulating layer 252 is greater than the linewidth W200 of the conductive line 200 at the ratio of 1:1.1 as described above, a process margin can be secured so that a short circuit between the unintended electrode and the conductive line 200 is properly prevented, even if some of the conductive lines 200 are arranged slightly slantly. Further, when the ratio of the linewidth W200 of the conductive line 200 to the first direction length L252 of the insulating layer 252 is equal to or less than 1: 2, the manufacturing cost can be reduced by preventing an excessive use of the insulating layer 252.

For example, the linewidth W200 of the conductive line 200 may be 1 mm to 2.5 mm, and the distance D200 between the conductive lines 200 may be equal to or greater than 2 mm and may be equal to or less than 0.5 times a length of the semiconductor substrate 110 in the first direction x. More preferably, the distance D200 between the conductive lines 200 may be 4 mm to 8 mm.

Further, the first direction length L252 of the insulating layer 252 may be equal to greater than the linewidth W200 of the conductive line 200 and may be less than the distance D200 between the conductive lines 200. Preferably, the first direction length L252 of the insulating layer 252 may be 1.1 mm to 4 mm in consideration of the process margin, the prevention of the short circuit, and the manufacturing cost.

In embodiments not covered by the invention, the first direction length L251 of the conductive adhesive 251 may be equal to or greater than the linewidth W200 of the conductive line 200 and may be less than the first direction length L252 of the insulating layer 252.

For example, a ratio of the linewidth W200 of the conductive line 200 to the first direction length L251 of the conductive adhesive 251 may be 1: 1 to 1: 1.25.

In embodiments not covered by the invention, when the ratio of the linewidth W200 of the conductive line 200 to the first direction length L251 of the conductive adhesive 251 is equal to or greater than 1: 1, the conductive line 200 can be more stably attached to an intended electrode through the conductive adhesive 251, and a contact resistance between the conductive line 200 and the intended electrode can be sufficiently reduced. When the ratio of the linewidth W200 of the conductive line 200 to the first direction length L251 of the conductive adhesive 251 is equal to or less than 1: 1.25, the manufacturing cost can be reduced by minimizing the use of the conductive adhesive 251.

In other words, in embodiments not covered by the invention, the first direction length L251 of the conductive adhesive 251 may be equal to or greater than the linewidth W200 of the conductive line 200 and may be less than the first direction length L252 of the insulating layer 252. Preferably, the first direction length L251 of the conductive adhesive 251 may be 1 mm to 3 mm in consideration of the above-described contact resistance and the manufacturing cost.

A ratio of the first direction length L251 of the conductive adhesive 251 to the first direction length L252 of the insulating layer 252 may be 1: 1.1 to 1: 1.7. When the ratio of the first direction length L251 of the conductive adhesive 251 to the first direction length L252 of the insulating layer 252 is equal to or greater than 1: 1.1, a short circuit between an unintended electrode and the conductive line 200 can be prevented.

When the ratio of the first direction length L251 of the conductive adhesive 251 to the first direction length L252 of the insulating layer 252 is equal to or less than 1: 1.7, the embodiment of the invention can secure a proper process margin during the tabbing process while preventing an excessive use of the insulating layer 252.

Further, linewidths W141 and W142 of the first and second electrodes 141 and 142 may be less than the first direction length L251 of the conductive adhesive 251 and the first direction length L252 of the insulating layer 252. For example, the linewidths W141and W142 of the first and second electrodes 141 and 142 may be 180 µm to 400 µm.

A distance DE between the first and second electrodes 141 and 142 may be less than the first direction length L251 of the conductive adhesive 251 and the first direction length L252 of the insulating layer 252. For example, the distance DE between the first and second electrodes 141 and 142 may be 0.5 mm to 1.5 mm.

A linewidth W251 of the conductive adhesive 251 may be less than the first direction length L251 of the conductive adhesive 251, and a linewidth W252 of the insulating layer 252 may be less than the first direction length L252 of the insulating layer 252.

More specifically, the linewidth W252 of the insulating layer 252 may be greater than the linewidth W251 of the conductive adhesive 251 in consideration of the prevention of the short circuit. For example, the linewidth W252 of the insulating layer 252 may be 200 µm to 450 µm, and the linewidth W251 of the conductive adhesive 251 may be 180 µm to 400 µm.

In this instance, the linewidth W251 of the conductive adhesive 251 may be substantially equal to the linewidths W141 and W142 of the first and second electrodes 141 and 142.

## Claims

1. A solar cell module comprising:
a plurality of solar cells (C1, C2) each including a semiconductor substrate and first and second electrodes (141, 142) that are formed on a back surface of the semiconductor substrate, the first and second electrodes extending in a first direction, and having different polarities; and
conductive lines (200) disposed to extend in a second direction crossing the first direction on the back surface of the semiconductor substrate included in each solar cell, the conductive lines including
first conductive lines (210) connected to the first electrodes (141) through a conductive adhesive (251) and insulated from the second electrodes (142) through an insulating layer (252), and
second conductive lines (220) connected to the second electrodes (142) through the conductive adhesive (251) and insulated from the first electrodes (141) through the insulating layer (252),
wherein a first direction length (L252) of the insulating layer (252) in the first direction is greater than a linewidth (W200) of each conductive line (200) and is less than a distance (D200) between the conductive lines (200), and
wherein the first direction length (L252) of the insulating layer (252) is greater than the first direction length (L251) of the conductive adhesive (251), and
a first direction length (L251) of the conductive adhesive (251) in the first direction is greater than a linewidth (W200) of each conductive line (200), is equal to or less than 1.25 times of the linewidth (W200) of each conductive line (200) and is less than a distance (D200) between the conductive lines (200).

2. The solar cell module of claim 1, wherein a ratio of the linewidth (W200) of each conductive line (200) to the first direction length (L252) of the insulating layer (252) is 1: 1.1 to 1:2.

3. The solar cell module of any one preceding claim, wherein the linewidth (W200) of each conductive line (200) is 1 mm to 2.5 mm, and
the distance (D200) between the conductive lines is equal to or greater than 2 mm and is equal to or less than 0.5 times a length of the semiconductor substrate in the second direction.

4. The solar cell module of any one preceding claim, wherein the distance (D200) between the conductive lines (200) is 4 mm to 8 mm.

5. The solar cell module of any one preceding claim, wherein a ratio of the first direction length of the conductive adhesive (251) to the first direction length of the insulating layer (252) is 1: 1.1 to 1: 1.7, and
wherein the first direction length (L251) of the conductive adhesive (251) is 1 mm to 3 mm, and the first direction length (L252) of the insulating layer (252) is 1.1 mm to 4 mm.

6. The solar cell module of any one preceding claim, wherein a linewidth (W141, W142) of each of the first and second electrodes (141, 142) is less than the first direction length (L251) of the conductive adhesive (251) and the first direction length (L252) of the insulating layer (252), and
wherein a linewidth of each of the first and second electrodes (141, 142) is 180 µm to 400 µm.

7. The solar cell module of any one preceding claim, wherein a distance (DE) between the first and second electrodes (141, 142) is less than the first direction length (L251) of the conductive adhesive (251) and the first direction length (L252) of the insulating layer (252), and
wherein a distance (DE) between the first and second electrodes (141, 142) is 0.5 mm to 1.5 mm.

8. The solar cell module of any one preceding claim, wherein a linewidth (L252) of the insulating layer (252) is greater than a linewidth (L251) of the conductive adhesive (251),
wherein the linewidth (L251) of the conductive adhesive (251) is substantially equal to a linewidth (W141, W142) of each of the first and second electrodes (141, 142), and
wherein the linewidth (L251) of the conductive adhesive (251) is 180 µm to 400 µm, and the linewidth (L252) of the insulating layer (252) is 200 µm to 450 µm.

9. The solar cell module of any one preceding claim, wherein the semiconductor substrate (110) of each solar cell is doped with impurities of a first conductive type,
wherein each solar cell further includes an emitter region (121) doped with impurities of a second conductive type opposite the first conductive type on the back surface of the semiconductor substrate and a back surface field region (172) more heavily doped than the semiconductor substrate with impurities of the first conductive type, and
wherein each first electrode (141) is connected to the emitter region (121), and each second electrode (142) is connected to the back surface field region (172).

10. The solar cell module of claim 1, wherein the plurality of solar cells include a first solar cell (C1) and a second solar cell (C2) that are arranged next to each other in the second direction and are connected in series to each other, and
wherein an interconnector (300) is disposed between the first solar cell and the second solar cell and connects the first solar cell and the second solar cell in series.

11. The solar cell module of claim 10, wherein the interconnector (300) is disposed to extend between the first solar cell and the second solar cell in the first direction.

12. The solar cell module of claim 10 or 11, wherein the first conductive lines (210) connected to the first solar cell and the second conductive lines (220) connected to the second solar cell are commonly connected to the interconnector (300).

13. The solar cell module of claim 12, wherein the first conductive lines (210) and the second conductive lines (220) are alternatingly arranged on the interconnector (300).

## Patentansprüche

1. Solarzellenmodul umfassend:
eine Mehrzahl von Solarzellen (C1, C2), welche jeweils ein Halbleitersubstrat und erste und zweite Elektroden (141, 142) enthalten, welche auf einer Rückseite des Halbleitersubstrats gebildet sind, wobei die ersten und zweiten Elektroden sich in einer ersten Richtung erstrecken und unterschiedliche Polaritäten aufweisen; und
leitfähige Linien (200), welche so angeordnet sind, dass sie sich in einer zweiten Richtung, welche die erste Richtung kreuzt, auf der Rückseite des Halbleitersubstrats jeder der Solarzellen erstrecken, wobei die leitfähigen Linien
erste leitfähige Linien (210) enthalten, welche durch ein leitfähiges Adhäsiv (251) mit den ersten Elektroden (141) verbunden sind und welche durch eine Isolierschicht (252) von den zweiten Elektroden (142) isoliert sind, und
zweite leitfähige Linien (220) enthalten, welche durch das leitfähige Adhäsiv (251) mit den zweiten Elektroden (142) verbunden sind und durch die Isolationsschicht (252) von den ersten Elektroden (141) isoliert sind,
wobei eine Länge in einer ersten Richtung (L252) der Isolierschicht (252) in der ersten Richtung größer ist als eine Linienbreite (W200) jeder der leitfähigen Linien (200) und weniger beträgt als eine Distanz (D200) zwischen den leitfähigen Linien (200), und
wobei die Länge in der ersten Richtung (L252) der Isolierschicht (252) größer ist als die Länge in der ersten Richtung (L251) des leitfähigen Adhäsivs (251), und
wobei eine Länge in einer ersten Richtung (L251) des leitfähigen Adhäsivs (251) in der ersten Richtung größer ist als eine Linienbreite (W200) jeder der leitfähigen Linien (200), gleich oder weniger beträgt als 1,25 Mal die Linienbreite (W200) jeder der leitfähigen Linien (200) und weniger beträgt als eine Distanz (D200) zwischen den leitfähigen Linien (200).

2. Solarzellenmodul nach Anspruch 1, wobei ein Verhältnis der Linienbreite (W200) jeder der leitfähigen Linien (200) zu der Länge in der ersten Richtung (L252) der Isolierschicht (252) 1:1,1 bis 1:2 beträgt.

3. Solarzellenmodul nach einem der vorhergehenden Ansprüche, wobei die Linienbreite (W200) jeder der leitfähigen Linien (200) 1 mm bis 2,5 mm beträgt, und
die Distanz (D200) zwischen den leitfähigen Linien gleich oder größer ist als 2 mm und gleich oder weniger beträgt als 0,5 Mal eine Länge des Halbleitersubstrats in der zweiten Richtung.

4. Solarzellenmodul nach einem vorhergehenden Anspruch, wobei die Distanz (D200) zwischen den leitfähigen Linien (200) 4 mm bis 8 mm beträgt.

5. Solarzellenmodul nach einem vorhergehenden Anspruch, wobei ein Verhältnis der Länge in der ersten Richtung des leitfähigen Adhäsivs (251) zu der Länge in der ersten Richtung der Isolierschicht (252) 1:1,1 bis 1:1,7 beträgt, und
wobei die Länge in der ersten Richtung (L251) des leitfähigen Adhäsivs (251) 1 mm bis 3 mm beträgt und die Länge in der ersten Richtung (L252) der Isolierschicht (252) 1,1 mm bis 4 mm beträgt.

6. Solarzellenmodul nach einem vorhergehenden Anspruch, wobei eine Linienbreite (W141, W142) jeder der ersten und zweiten Elektroden (141, 142) weniger beträgt als die Länge in der ersten Richtung (L252) des leitfähigen Adhäsivs (251) und die Länge in der ersten Richtung (L252) der Isolierschicht (252), und wobei eine Linienbreite jeder der ersten und zweiten Elektroden (141, 142) 180 µm bis 400 µm beträgt.

7. Solarzellenmodul nach einem der vorhergehenden Ansprüche, wobei eine Distanz (DE) zwischen den ersten und zweiten Elektroden (141, 142) weniger beträgt als die Länge in der ersten Richtung (L252) des leitfähigen Adhäsivs (251) und die Länge in der ersten Richtung (L252) der Isolierschicht (252), und
wobei einer Distanz (DE) zwischen den ersten und zweiten Elektroden (141, 142) 0,5 mm bis 1,5 mm beträgt.

8. Solarzellenmodul nach einem der vorhergehenden Ansprüche, wobei eine Linienbreite (L252) der Isolierschicht (252) größer ist als eine Linienbreite (L251) des leitfähigen Adhäsivs (251),
wobei die Linienbreite (L251) des leitfähigen Adhäsivs (251) im Wesentlichen gleich zu einer Linienbreite (W141, W142) jeder der ersten und zweiten Elektroden (141, 142) ist, und
wobei die Linienbreite (L251) des leitfähigen Adhäsivs (251) 180 µm bis 400 µm beträgt und die Linienbreite (L252) der Isolierschicht (252) 200 µm bis 450 µm beträgt.

9. Solarzellenmodul nach einem der vorhergehenden Ansprüche, wobei das Halbleitersubstrat (110) jeder der Solarzellen mit Störstellen eines ersten Leitfähigkeitstyps dotiert ist,
wobei jede Solarzelle des Weiteren einen Emitterbereich (121), der mit Störstellen eines zweiten Leitfähigkeitstyps, der zu dem ersten Leitfähigkeitstyp entgegengesetzt ist, dotiert ist, auf der Rückseite des Halbleitersubstrats enthält, und einen Rückseitenfeldbereich (172), der stärker mit Störstellen des ersten Leitfähigkeitstyps als das Halbleitersubstrat dotiert ist, enthält, und
wobei jede erste Elektrode (141) mit dem Emitterbereich (121) verbunden ist, und jede zweite Elektrode (142) mit dem Rückseitenfeldbereich (172) verbunden ist.

10. Solarzellenmodul nach Anspruch 1, wobei die Mehrzahl Solarzellen eine erste Solarzelle (C1) und eine zweite Solarzelle (C2) enthält, die in der zweiten Richtung nebeneinander angeordnet sind und miteinander in Serie verbunden sind, und
wobei ein Interkonnektor (300) zwischen der ersten Solarzelle und der zweiten Solarzelle angeordnet ist und die erste Solarzelle und die zweite Solarzelle in Serie verbindet.

11. Solarzellenmodul nach Anspruch 10, wobei der Interkonnektor (300) so angeordnet ist, dass er sich zwischen der ersten Solarzelle und der zweiten Solarzelle in der ersten Richtung erstreckt.

12. Solarzellenmodul nach Anspruch 10 oder 11, wobei die mit der ersten Solarzelle verbundenen ersten leitfähigen Linien (210) und die mit der zweiten Solarzelle verbundenen zweiten leitfähigen Linien (220) gemeinsam mit dem Interkonnektor (300) verbunden sind.

13. Solarzellenmodul nach Anspruch 12, wobei die ersten leitfähigen Linien (210) und die zweiten Leitfähigen Linien (220) alternierend auf dem Interkonnektor (300) angeordnet sind.

## Revendications

1. Module de cellules solaires comprenant :
une pluralité de cellules solaires (C1, C2) comprenant chacune un substrat semi-conducteur et des première et seconde électrodes (141, 142) qui sont formées sur une surface arrière du substrat semi-conducteur, les première et seconde électrodes s'étendant dans une première direction, et ayant des polarités différentes ; et
des lignes conductrices (200) disposées pour s'étendre dans une seconde direction croisant la première direction sur la surface arrière du substrat semi-conducteur inclus dans chaque cellule solaire, les lignes conductrices comprenant
des premières lignes conductrices (210) connectées aux premières électrodes (141) par un adhésif conducteur (251) et isolées des secondes électrodes (142) par une couche isolante (252), et
des secondes lignes conductrices (220) connectées aux secondes électrodes (142) par l'adhésif conducteur (251) et isolées des premières électrodes (141) par la couche isolante (252),
dans lequel une première longueur de direction (L252) de la couche isolante (252) dans la première direction est supérieure à une largeur de ligne (W200) de chaque ligne conductrice (200) et est inférieure à une distance (D200) entre les lignes conductrices (200), et
dans lequel la première longueur de direction (L252) de la couche isolante (252) est supérieure à la première longueur de direction (L251) de l'adhésif conducteur (251), et
une première longueur de direction (L251) de l'adhésif conducteur (251) dans la première direction est supérieure à une largeur de ligne (W200) de chaque ligne conductrice (200), est inférieure ou égale à 1,25 fois la largeur de ligne (W200) de chaque ligne conductrice (200) et est inférieure à une distance (D200) entre les lignes conductrices (200).

2. Module de cellules solaires selon la revendication 1, dans lequel le rapport de la largeur de ligne (W200) de chaque ligne conductrice (200) à la première longueur de direction (L252) de la couche isolante (252) est compris entre 1:1,1 et 1:2.

3. Module de cellules solaires selon l'une quelconque des revendications précédentes, dans lequel la largeur de ligne (W200) de chaque ligne conductrice (200) est comprise entre 1 mm et 2,5 mm, et
la distance (D200) entre les lignes conductrices est supérieure ou égale à 2 mm et est inférieure ou égale à 0,5 fois la longueur du substrat semi-conducteur dans la seconde direction.

4. Module de cellules solaires selon l'une quelconque des revendications précédentes, dans lequel la distance (D200) entre les lignes conductrices (200) est comprise entre 4 mm et 8 mm.

5. Module de cellules solaires selon l'une quelconque des revendications précédentes, dans lequel le rapport de la première longueur de direction de l'adhésif conducteur (251) à la première longueur de direction de la couche isolante (252) est compris entre 1:1,1 et 1:1,7, et
dans lequel la première longueur de direction (L251) de l'adhésif conducteur (251) est comprise entre 1 mm et 3 mm, et la première longueur de direction (L252) de la couche isolante (252) est comprise entre 1,1 mm et 4 mm.

6. Module de cellules solaires selon l'une quelconque des revendications précédentes, dans lequel une largeur de ligne (W141, W142) de chacune des première et seconde électrodes (141, 142) est inférieure à la première longueur de direction (L251) de l'adhésif conducteur (251) et à la première longueur de direction (L252) de la couche isolante (252), et
dans lequel la largeur de ligne de chacune des première et seconde électrodes (141, 142) est comprise entre 180 µm et 400 µm.

7. Module de cellules solaires selon l'une quelconque des revendications précédentes, dans lequel une distance (DE) entre les première et seconde électrodes (141, 142) est inférieure à la première longueur de direction (L251) de l'adhésif conducteur (251) et à la première longueur de direction (L252) de la couche isolante (252), et
dans lequel une distance (DE) entre les première et seconde électrodes (141, 142) est comprise entre 0,5 mm et 1,5 mm.

8. Module de cellules solaires selon l'une quelconque des revendications précédentes, dans lequel une largeur de ligne (L252) de la couche isolante (252) est supérieure à une largeur de ligne (L251) de l'adhésif conducteur (251),
dans lequel la largeur de ligne (L251) de l'adhésif conducteur (251) est sensiblement égale à une largeur de ligne (W141, W142) de chacune des première et seconde électrodes (141, 142), et
dans lequel la largeur de ligne (L251) de l'adhésif conducteur (251) est comprise entre 180 µm et 400 µm, et la largeur de ligne (L252) de la couche isolante (252) est comprise entre 200 µm et 450 µm.

9. Module de cellules solaires selon l'une quelconque des revendications précédentes, dans lequel le substrat semi-conducteur (110) de chaque cellule solaire est dopé avec des impuretés d'un premier type conducteur,
dans lequel chaque cellule solaire comprend en outre une région d'émetteur (121) dopée avec des impuretés d'un second type conducteur opposé au premier type conducteur sur la surface arrière du substrat semi-conducteur et une région de champ de surface arrière (172) plus fortement dopée que le substrat semi-conducteur avec des impuretés du premier type conducteur, et
dans lequel chaque première électrode (141) est connectée à la région d'émetteur (121), et chaque seconde électrode (142) est connectée à la région de champ de surface arrière (172).

10. Module de cellules solaires selon la revendication 1, dans lequel la pluralité de cellules solaires comprend une première cellule solaire (C1) et une seconde cellule solaire (C2) qui sont agencées côte à côte dans la seconde direction et qui sont connectées en série l'une à l'autre, et
dans lequel un interconnecteur (300) est disposé entre la première cellule solaire et la seconde cellule solaire et connecte la première cellule solaire et la seconde cellule solaire en série.

11. Module de cellules solaires selon la revendication 10, dans lequel l'interconnecteur (300) est disposé de sorte à s'étendre entre la première cellule solaire et la seconde cellule solaire dans la première direction.

12. Module de cellules solaires selon la revendication 10 ou 11, dans lequel les premières lignes conductrices (210) connectées à la première cellule solaire et les secondes lignes conductrices (220) connectées à la seconde cellule solaire sont connectées de manière commune à l'interconnecteur (300).

13. Module de cellules solaires selon la revendication 12, dans lequel les premières lignes conductrices (210) et les secondes lignes conductrices (220) sont agencées en alternance sur l'interconnecteur (300).
